# EUROPEAN PATENT APPLICATION

(11) **EP 4 791 142 A2**
(43) Date of publication of application: **12.08.2026**
(21) Application number: 25220991.1
(22) Date of filing: 05.12.2025
(51) Int. Cl.: H10B 41/10, H10B 43/10, H10B 41/27, H10B 43/27

(54) **SEMICONDUCTOR DEVICE AND METHOD OF MANUFACTURING A SEMICONDUCTOR DEVICE**

(30) Priority: 05.02.2025 KR 20250014671
(71) Applicant: SK hynix Inc., Bubal-eub Icheon-si Gyeonggi-do 17336 (KR)
(72) Inventor: LEE, Sang Min, 17336 Icheon-si, Gyeonggi-do (KR); LEE, Sang Bum, 17336 Icheon-si, Gyeonggi-do (KR)
(74) Representative: Isarpatent

(57) **Abstract**

A semiconductor device includes a gate structure including insulating layers and conductive layers alternately stacked, channel structures (120) extending through the gate structure and arranged in a first direction (I) and a second direction (II) crossing the first direction, a slit structure (130) extending in the first direction and including a body portion (130A) and protrusions (130B) protruding from the body portion in the second direction, and dummy structures (140) arranged in the first direction between the channel structures and the slit structure and respectively contacting the protrusions.

## Description

### BACKGROUND

### 1. Technical Field

The present disclosure generally relates to an electronic device and a method of manufacturing the electronic device, and more particularly, to a semiconductor device and a method of manufacturing the semiconductor device.

### 2. Related Art

An integration degree of a semiconductor device is mainly determined by an area occupied by a unit memory cell. Recently, as improvement in an integration degree of a semiconductor device in which a memory cell is formed as a single layer on a substrate reaches a limit, a three-dimensional semiconductor device in which memory cells are stacked on a substrate is being proposed. In addition, various structures and manufacturing methods are being developed in order to improve operation reliability of the semiconductor device.

### SUMMARY

According to an embodiment of the present disclosure, a semiconductor device may include a gate structure including insulating layers and conductive layers alternately stacked in a third direction, channel structures extending through the gate structure in the third direction and arranged in a first direction and a second direction crossing the first direction, a slit structure extending in the first direction and including a body portion and protrusions protruding from the body portion in the second direction, and dummy structures arranged in the first direction between the channel structures and the slit structure and respectively contacting the protrusions.

According to an embodiment of the present disclosure, a semiconductor device may include a gate structure including insulating layers and conductive layers alternately stacked in a third direction, channel structures extending through the gate structure in the third direction and arranged in a first direction and a second direction crossing the first direction, a slit structure extending in the first direction, and dummy structures arranged in the first direction between the channel structures and the slit structure, the channel structures may be spaced apart from each other by a first interval, and channel structures located adjacent to the dummy structures among the channel structures are spaced apart from corresponding adjacent dummy structures, respectively, by a third interval, the third interval is substantially equal to the first interval.

According to an embodiment of the present disclosure, a method of manufacturing a semiconductor device may include forming a stack by alternately stacking first material layers and second material layers in a third direction, forming channel holes, dummy holes, and slit holes extending through the stack in the third direction, forming channel structures in the channel holes, respectively, forming dummy structures in the dummy holes, respectively, and forming a slit exposing the dummy structures by expanding the slit holes.

According to an embodiment of the present disclosure, a method of manufacturing a semiconductor device may include forming a stack by alternately stacking first material layers and second material layers in a third direction, forming channel holes extending through the stack in the third direction and spaced apart from each other by a first interval, forming dummy holes extending through the stack in the third direction and spaced apart from each other by a second interval substantially equal to the first interval, forming slit holes extending through the stack in the third direction and spaced apart from each other by a fourth interval substantially equal to the first interval, forming channel structures in the channel holes, respectively, forming dummy structures in the dummy holes, respectively, and forming a slit by expanding the slit holes, channel holes located adjacent to the dummy holes among the channel holes may be formed spaced apart from the dummy holes by a third interval substantially equal to the first interval, and the dummy holes and the slit holes may be formed spaced apart by a fifth interval substantially equal to the first interval.

### BRIEF DESCRIPTION OF THE DRAWINGS

FIGS. 1A and 1B are drawings illustrating a semiconductor device according to an embodiment of the present disclosure.
FIGS. 2A and 2B are drawings illustrating a semiconductor device according to an embodiment of the present disclosure.
FIGS. 3A and 3B are drawings illustrating a semiconductor device according to an embodiment of the present disclosure.
FIG. 4 is a drawing illustrating a semiconductor device according to an embodiment of the present disclosure.
FIG. 5 is a drawing illustrating a semiconductor device according to an embodiment of the present disclosure.
FIGS. 6A, 6B, 7A, 7B, 8A, 8B, 9A, 9B, 10A, and FIG. 10B are drawings illustrating a method of manufacturing a semiconductor device according to an embodiment of the present disclosure.
FIGS. 11A, 11B, 12A, 12B, 13A, 13B, 14A, and 14B are drawings illustrating a method of manufacturing a semiconductor device according to an embodiment of the present disclosure.
FIGS. 15A, 15B, 16A, 16B, 17A, 17B, 18A, and 18B are drawings illustrating a method of manufacturing a semiconductor device according to an embodiment of the present disclosure.

### DETAILED DESCRIPTION

An embodiment of the present disclosure provides a semiconductor device and a method of manufacturing the semiconductor device having a stable structure and an improved characteristic.

According to an embodiment of the present technology, a semiconductor device having a stable structure and improved reliability may be provided.

Hereinafter, embodiments according to the technical spirit of the present disclosure are described with reference to the accompanying drawings.

Terms such as "first" and "second" are used to distinguish between various elements and do not imply size, order, priority, quantity, or importance of the elements. For example, a first element may be named as a second element in one example, and the second element may be named as a first element in another example. Terms such as "vertical," "horizontal," "over," "side," "lower," "outer" and other terms implying relative spatial relationship or orientation are utilized only for the purpose of ease of description or reference to a drawing and are not otherwise limiting. The cross-hatching throughout the figures illustrates corresponding or similar areas between the figures rather than indicating the materials associated with the areas. It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the example of the term "below" can encompass both an orientation of above and below. The device may be otherwise oriented (rotated 90 degrees or at other orientations) and the spatially relative descriptors used herein interpreted accordingly.

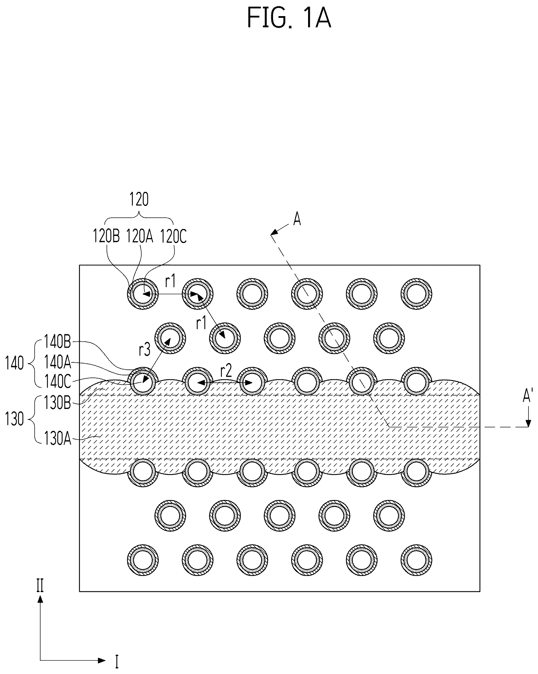

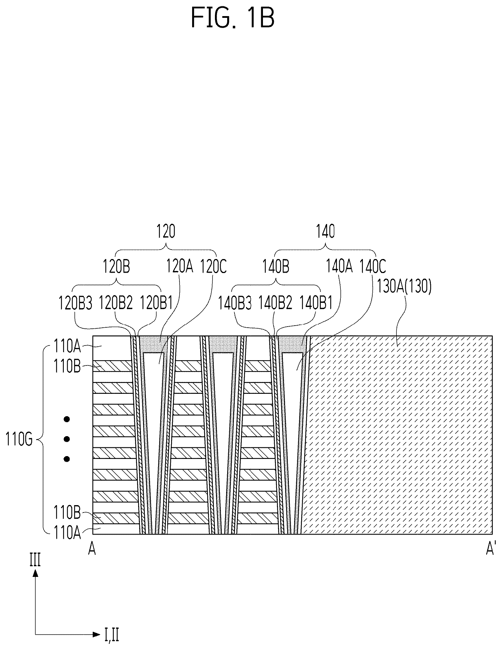

FIGS. 1A and 1B are drawings illustrating a semiconductor device according to an embodiment of the present disclosure. FIG. 1A is a plan view, and FIG. 1B is an A-A' cross-sectional view of FIG. 1A.

Referring to FIGS. 1A and 1B, the semiconductor device may include a gate structure 110G, channel structures 120, a slit structure 130, and dummy structures 140.

The gate structure 110G may include insulating layers 110A and conductive layers 110B alternately stacked. Here, a stack direction may mean a third direction III crossing a first direction I and a second direction II based on a plane defined by the first direction I and the second direction II crossing the first direction I. The conductive layers 110B may be a gate line such as a source selection line, a word line, and a drain selection line. A source selection transistor, a memory cell, or a drain selection transistor may be located in a region where the channel structures 120 and the conductive layers 110B cross. For example, at least one source selection transistor, a plurality of memory cells, and at least one drain selection transistor stacked along the channel structure 120 may configure one memory string. The conductive layers 110B may include a conductive material such as tungsten, molybdenum, or polysilicon. The insulating layers 110A may include an insulating material such as an oxide.

The channel structures 120 may extend through the gate structure 110G. For example, the channel structures 120 may extend through the gate structure 110G in the third direction III. Each of the channel structures 120 may include a real channel layer 120A, a real memory layer 120B surrounding the real channel layer 120A, and a real insulating core 120C in the real channel layer 120A. Here, the real memory layer 120B may include a real tunneling layer 120B1, a real data storage layer 120B2, and a real blocking layer 120B3. The real tunneling layer 120B1 and the real blocking layer 120B3 may include an oxide, and the real data storage layer 120B2 may include a nitride.

The channel structures 120 may be arranged in the first direction I and the second direction II. In other words, the channel structures 120 may be arranged in the first direction I and the second direction II in a plane defined by the first direction I and the second direction II. In addition, the channel structures 120 may be spaced apart from each other by a first interval r1 in the plane.

The slit structure 130 may extend through the gate structure 110G in the third direction III. The slit structure 130 may extend in the first direction I in the plane. The slit structure 130 may include a body portion 130A and protrusions 130B. Here, the protrusions 130B may protrude from the body portion 130A in the second direction II. The slit structure 130 may include an insulating material such as an oxide.

The dummy structures 140 may extend through the gate structure 110G in the third direction III. Each of the dummy structures 140 may include a dummy channel layer 140A, a dummy memory layer 140B surrounding the dummy channel layer 140A, and a dummy insulating core 140C in the dummy channel layer 140A. The dummy channel layer 140A may correspond to the real channel layer 120A, the dummy memory layer 140B may correspond to the real memory layer 120B, and the dummy insulating core 140C may correspond to the real insulating core 120C. The dummy memory layer 140B may include a dummy tunneling layer 140B1, a dummy data storage layer 140B2, and a dummy blocking layer 140B3. The dummy tunneling layer 140B1 and the dummy blocking layer 140B3 may include an oxide, and the dummy data storage layer 140B2 may include a nitride.

The dummy memory layer 140B may surround a portion of the dummy channel layer 140A. For example, the dummy tunneling layer 140B1 may surround the entire sidewall of the dummy channel layer 140A, and the dummy data storage layer 140B2 and the dummy blocking layer 140B3 may surround a portion of the sidewall of the dummy channel layer 140A. This is because a portion of the dummy data storage layer 140B2 and the dummy blocking layer 140B3 may be removed in a process of manufacturing the semiconductor device.

The dummy structures 140 may be arranged in the first direction I in the plane. For example, the dummy structures 140 may be arranged in the first direction I between the channel structures 120 and the slit structure 130. Here, the dummy structures 140 may contact the protrusions 130B of the slit structure 130. The protrusions 130B may protrude between the dummy structures 140 in the second direction II.

The dummy structures 140 may be spaced apart from each other in the plane by a second interval r2. Here, the second interval r2 may be substantially equal to the first interval r1. Among the channel structures 120, channel structures 120 located adjacent to the dummy structures 140 may be spaced apart from each other by a third interval r3. In an embodiment, among the channel structures 120, channel structures 120 located adjacent to the dummy structures 140 may be spaced apart from a corresponding adjacent dummy structure 140 by a third interval r3 as shown, for example, in FIG. 1A. Here, the third interval r3 may be substantially equal to the first interval r1. In other words, all of the first interval r1, the second interval r2, and the third interval r3 may be equal.

According to an embodiment of the present disclosure, the dummy structures 140 may contact the protrusions 130B of the slit structure 130. This is because the dummy structures 140 may be exposed and a portion of the dummy structures 140 may be etched in a process of forming the slit structure 130. In other words, the dummy structures 140 may be located between the slit structure 130 and the channel structures 120, and, in an embodiment, may prevent or reduce damage to the channel structures 120 in the process of forming the slit structure 130.

According to an embodiment of the structure described above, the dummy structures 140 may be located between the slit structure 130 and the channel structures 120. In an embodiment, the dummy structures 140 may protect the channel structures 120 in the process of forming the slit structure 130. In an embodiment, the dummy structures 140 may have a structure similar to the channel structures 120.

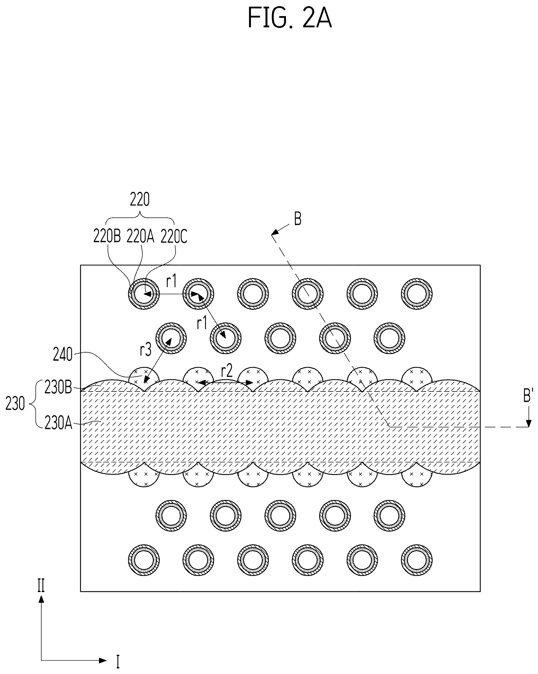

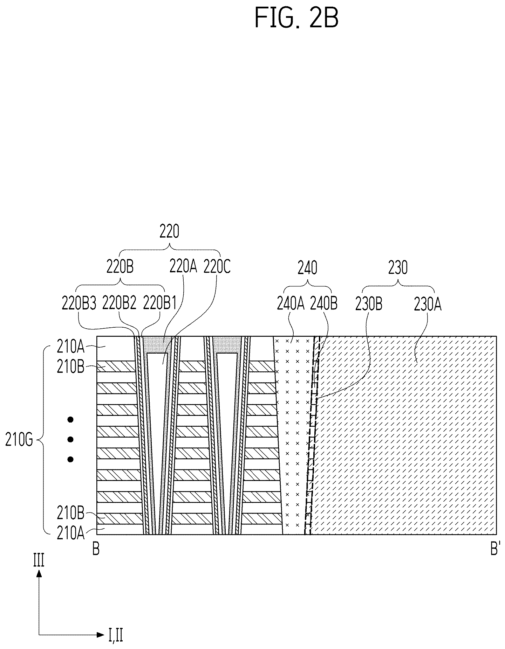

FIGS. 2A and 2B are drawings illustrating a semiconductor device according to an embodiment of the present disclosure. FIG. 2A is a plan view, and FIG. 2B is a B-B' cross-sectional view of FIG. 2A. Hereinafter, a content that overlaps the content described above is omitted.

Referring to FIGS. 2A and 2B, the semiconductor device may include a gate structure 210G, channel structures 220, a slit structure 230, and dummy structures 240.

The gate structure 210G may include insulating layers 210A and conductive layers 210B alternately stacked. The conductive layers 210B may be a gate line such as a source selection line, a word line, and a drain selection line. The conductive layers 210B may include a conductive material such as tungsten, molybdenum, or polysilicon. The insulating layers 210A may include an insulating material such as an oxide.

The channel structures 220 may extend through the gate structure 210G. Each of the channel structures 220 may include a real channel layer 220A, a real memory layer 220B surrounding the real channel layer 220A, and a real insulating core 220C in the real channel layer 220A. Here, the real memory layer 220B may include a real tunneling layer 220B1, a real data storage layer 220B2, and a real blocking layer 220B3. The real tunneling layer 220B1 and the real blocking layer 220B3 may include an oxide, and the real data storage layer 220B2 may include a nitride. The channel structures 220 may be arranged in a first direction I and a second direction II. In addition, the channel structures 220 may be spaced apart from each other by a first interval r1 in a plane.

The slit structure 230 may extend through the gate structure 210G. The slit structure 230 may extend in the first direction I in the plane. The slit structure 230 may include a body portion 230A and protrusions 230B. Here, the protrusions 230B may protrude from the body portion 230A in the second direction II. Alternatively, the protrusions 230B may be located at a level corresponding to the insulating layers 210A in a cross-section defined in the first/second I/ II and third directions III.

The dummy structures 240 may extend through the gate structure 210G. Each of the dummy structures 240 may include a first portion 240A extending through the gate structure 210G and second portions 240B protruding from the first portion. Here, the second portions 240B may be located between the first portion 240A and the slit structure 230. In other words, the second portions 240B may be located on one sidewall of the dummy structures 240. In addition, the second portions 240B may be located at a level corresponding to the conductive layers 210B in the cross-section. In other words, the protrusions 230B of the slit structure 230 and the second portions 240B of the dummy structures 240 may have a form in which the protrusions 230B of the slit structure 230 and the second portions 240B of the dummy structures 240 are alternately arranged in the cross-section. The dummy structures 240 may include an insulating material such as an oxide.

The dummy structures 240 may be arranged in the first direction I in the plane. For example, the dummy structures 240 may be arranged in the first direction I between the channel structures 220 and the slit structure 230. Here, the dummy structures 240 may contact the protrusions 230B of the slit structure 230. The protrusions 230B may protrude between the dummy structures 240 in the second direction II.

The dummy structures 240 may be spaced apart from each other by a second interval r2 in the plane. Here, the second interval r2 may be substantially equal to the first interval r1. Among the channel structures 220, channel structures 220 located adjacent to the dummy structures 240 may be spaced apart from the dummy structures 240 by a third interval r3. In an embodiment, among the channel structures 220, channel structures 220 located adjacent to the dummy structures 240 may be spaced apart from a corresponding adjacent dummy structure 240 by a third interval r3 as shown, for example, in FIG. 2A. Here, the third interval r3 may be substantially equal to the first interval r1. In other words, all of the first interval r1, the second interval r2, and the third interval r3 may be equal.

According to an embodiment of the present disclosure, the dummy structures 240 may have a shape in which a circle is partially etched in the plane. For example, the dummy structures 240 may have a fan shape. This is because the dummy structures 240 may be exposed and a portion of the dummy structures 240 may be etched in a process of forming the slit structure 230. In other words, in an embodiment, the dummy structures 240 may be located between the slit structure 230 and the channel structures 220, and may prevent or reduce damage to the channel structures 220 in the process of forming the slit structure 230.

According to an embodiment of the structure described above, the dummy structures 240 may be located between the slit structure 230 and the channel structures 220. In an embodiment, the dummy structures 240 may protect the channel structures 220 in the process of forming the slit structure 230. Here, the dummy structures 240 may be a single layer including an insulating material such as an oxide.

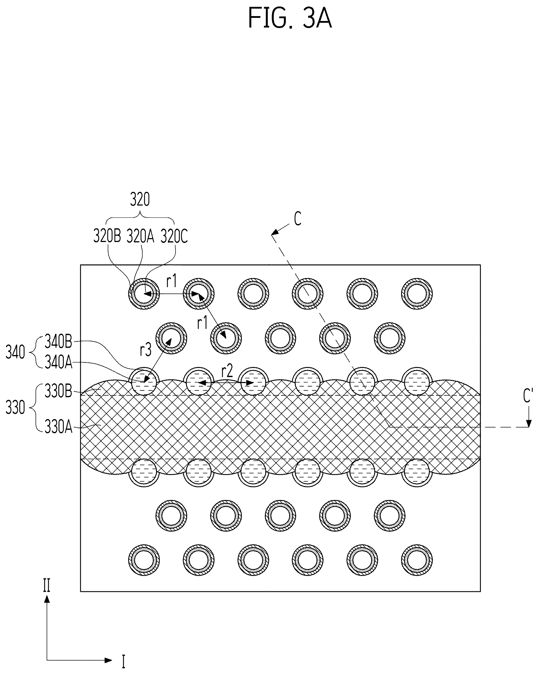

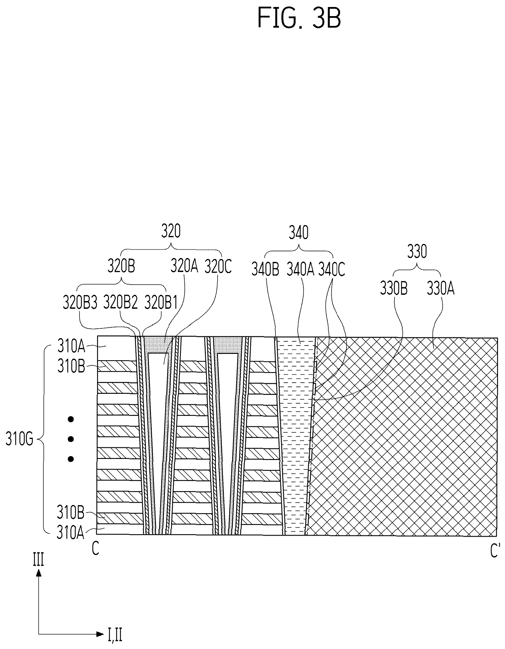

FIGS. 3A and 3B are drawings illustrating a semiconductor device according to an embodiment of the present disclosure. FIG. 3A is a plan view, and FIG. 3B is a C-C' cross-sectional view of FIG. 3A. Hereinafter, a content that overlaps the content described above is omitted.

Referring to FIGS. 3A and 3B, the semiconductor device may include a gate structure 310G, channel structures 320, a slit structure 330, and dummy structures 340.

The gate structure 310G may include insulating layers 310A and conductive layers 310B alternately stacked. The conductive layers 310B may be a gate line such as a source selection line, a word line, and a drain selection line. The conductive layers 310B may include a conductive material such as tungsten, molybdenum, or polysilicon. The insulating layers 310A may include an insulating material such as an oxide.

The channel structures 320 may extend through the gate structure 310G. Each of the channel structures 320 may include a real channel layer 320A, a real memory layer 320B surrounding the real channel layer 320A, and a real insulating core 320C in the real channel layer 320A. Here, the real memory layer 320B may include a real tunneling layer 320B1, a real data storage layer 320B2, and a real blocking layer 320B3. The real tunneling layer 320B1 and the real blocking layer 320B3 may include an oxide, and the real data storage layer 320B2 may include a nitride. The channel structures 320 may be arranged in a first direction I and a second direction II. In addition, the channel structures 320 may be spaced apart from each other by a first interval r1 in a plane.

The slit structure 330 may extend through the gate structure 310G. The slit structure 330 may extend in the first direction I in the plane. The slit structure 330 may include a body portion 330A and protrusions 330B. Here, the protrusions 330B may protrude from the body portion 230A in the second direction II. Alternatively, the protrusions 330B may be located at a level corresponding to the insulating layers 310A in a cross-section.

The dummy structures 340 may extend through the gate structure 310G. Each of the dummy structures 340 may include a first portion 340A extending through the gate structure 310G, a second portion 340B surrounding the first portion 340A, and third portions 340C protruding from the first portion 340A.

The second portion 340B may surround one sidewall of the first portion 340A, and the third portions 340C may surround another sidewall of the first portion 340A. Here, the second portion 340B may surround a portion of the first portion 340A. The third portions 340C may be located between the first portion 340A and the slit structure 330.

In addition, the third portions 340C may be located at a level corresponding to the conductive layers 310B in the cross-section. In other words, the protrusions 330B of the slit structure 330 and the second portions 340B of the dummy structures 340 may have a form in which the protrusions 330B of the slit structure 330 and the second portions 340B of the dummy structures 340 are alternately arranged in the cross-section. The first portion 340A may include a material different from a material of the second and third portions 340B and 340C. For example, the first portion 340A may include polysilicon, and the second and third portions 340B and 340C may include an oxide.

The dummy structures 340 may be arranged in the first direction I in the plane. For example, the dummy structures 340 may be arranged in the first direction I between the channel structures 320 and the slit structure 330. Here, the dummy structures 340 may contact the protrusions 330B of the slit structure 330. The protrusions 330B may protrude between the dummy structures 340 in the second direction II.

The dummy structures 340 may be spaced apart from each other by a second interval r2 in the plane. Here, the second interval r2 may be substantially equal to the first interval r1. Among the channel structures 320, channel structures 320 located adjacent to the dummy structures 340 may be spaced apart from the dummy structures 340 by a third interval r3. In an embodiment, among the channel structures 320, channel structures 320 located adjacent to the dummy structures 340 may be spaced apart from a corresponding adjacent dummy structure 340 by a third interval r3 as shown, for example, in FIG. 3A. Here, the third interval r3 may be substantially equal to the first interval r1. In other words, all of the first interval r1, the second interval r2, and the third interval r3 may be substantially equal.

According to an embodiment of the present disclosure, the dummy structures 340 may contact the protrusions 330B of the slit structure 330. This is because the dummy structures 340 may be exposed and a portion of the dummy structures 340 may be etched in a process of forming the slit structure 330. Here, the body portion 340A might not be etched, and the second portion 340B may be etched to form the third portions 340C. In other words, in an embodiment, the dummy structures 340 may be located between the slit structure 330 and the channel structures 320, and may prevent or reduce damage to the channel structures 320 in the process of forming the slit structure 330.

According to an embodiment of the structure described above, the dummy structures 340 may be located between the slit structure 330 and the channel structures 320. In an embodiment, the dummy structures 340 may protect the channel structures 320 in the process of forming the slit structure 330. Here, the dummy structures 340 may be multiple layers including the second and third portions 340B and 340C including an insulating material such as an oxide and the first portion 340A including polysilicon.

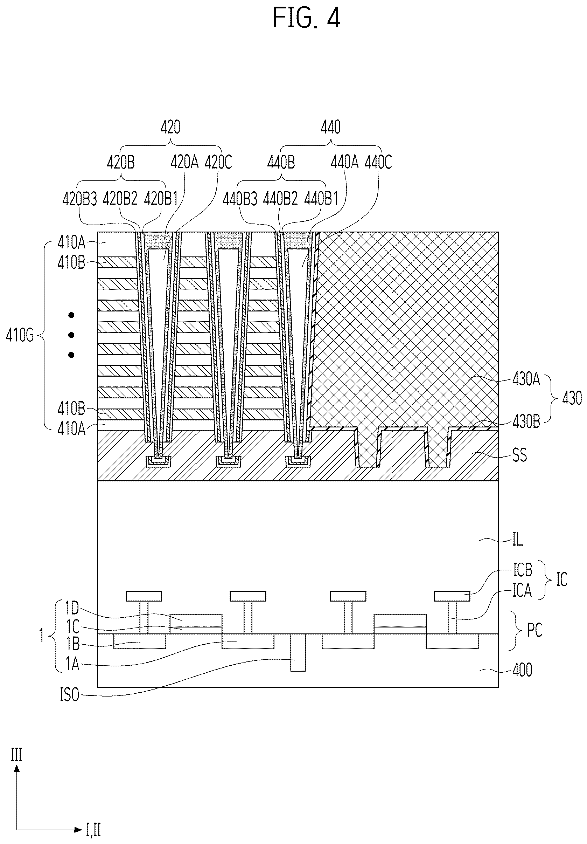

FIG. 4 is a drawing illustrating a semiconductor device according to an embodiment of the present disclosure. Hereinafter, a content that overlaps the content described above is omitted.

Referring to FIG. 4, the semiconductor device may include a substrate 400, a peripheral circuit PC, an element isolation layer ISO, an interconnection structure IC, an interlayer insulating layer IL, a source structure SS, a gate structure 410G, channel structures 420, dummy structures 440, and a slit structure 430.

The peripheral circuit PC may be located on the substrate 400. The peripheral circuit PC may include a transistor 1, a capacitor, and the like. The transistor 1 may include junctions 1A and 1B, a gate electrode 1D, and a gate insulating layer 1C. Here, the gate insulating layer 1C may be located between the gate electrode 1D and the substrate 400. The element isolation layer ISO may be located in the substrate 400, an active region may be defined by the element isolation layer ISO, and the transistor 1 may be located in the active region.

The interconnection structure IC may be located on the peripheral circuit PC. The interconnection structure IC may be located in the interlayer insulating layer IL. Here, the interlayer insulating layer IL may be located on the substrate 400. The interconnection structure IC may include vias ICA and lines ICB.

The interconnection structure IC may be connected to the peripheral circuit PC. For example, at least one of the vias ICA may be connected to the transistor 1. At least one of the vias ICA may interconnect the lines ICB. The lines ICB may interconnect the vias ICA. The interconnection structure IC may include a conductive material such as tungsten. The interlayer insulating layer IL may include an insulating material such as an oxide.

The gate structure 410G may be located on the source structure SS. Here, the source structure SS may be located between the peripheral circuit PC and the gate structure 410G. The gate structure 410G may include insulating layers 410A and conductive layers 410B alternately stacked.

The channel structures 420 may extend into the source structure SS through the gate structure 410G. Each of the channel structures 420 may include a real channel layer 420A, a real memory layer 420B surrounding the real channel layer 420A, and a real insulating core 420C in the real channel layer 420A. Here, the real channel layer 420A may be connected to the source structure SS. Here, the real memory layer 420B may include a real tunneling layer 420B1, a real data storage layer 420B2, and a real blocking layer 420B3. The real tunneling layer 420B1 and the real blocking layer 420B3 may include an oxide, and the real data storage layer 420B2 may include a nitride.

The dummy structure 440 may extend into the source structure SS through the gate structure 410G. The dummy structure 440 may have a structure similar to the channel structures 420. For example, the dummy structure 440 may include a dummy channel layer 440A, a dummy memory layer 440B surrounding the dummy channel layer 440A, and a dummy insulating core 440C in the dummy channel layer 440A. The dummy channel layer 440A may correspond to the real channel layer 420A, the dummy memory layer 440B may correspond to the real memory layer 420B, and the dummy insulating core 440C may correspond to the real insulating core 420C. The dummy memory layer 440B may include a dummy tunneling layer 440B1, a dummy data storage layer 440B2, and a dummy blocking layer 440B3. The dummy tunneling layer 440B1 and the dummy blocking layer 440B3 may include an oxide, and the dummy data storage layer 440B2 may include a nitride.

The slit structure 430 may extend into the source structure SS through the gate structure 410G. The slit structure 430 may include a source contact structure 430A and an insulating spacer 430B surrounding the source contact structure 430A. Here, the source contact structure 430A may be connected to the source structure SS. The insulating spacer 430B may insulate the source contact structure 430A and the conductive layers 410B.

For reference, the dummy structure 440 may have a shape similar to a shape of the dummy structures 240 and 340 of FIGS. 2B and 3B in addition to having the structure similar to the channel structures 420. The slit structure 430 may have a shape similar to a shape of the slit structures 130, 230, and 330 of FIGS. 1B, 2B, and 3B in addition to including the source contact structure 430A and the insulating spacers 430B.

According to the structure described above, the source structure SS may be located on the peripheral circuit PC, and the gate structure 410G may be located on the source structure SS. The channel structures 420 may extend into the source structure SS through the gate structure 410G, and the channel layer 420A of the channel structures 420 may be connected to the source structure SS. The slit structure 430 may extend into the source structure SS through the gate structure 410G, and the source contact structure 430A of the slit structure 430 may be connected to the source structure SS.

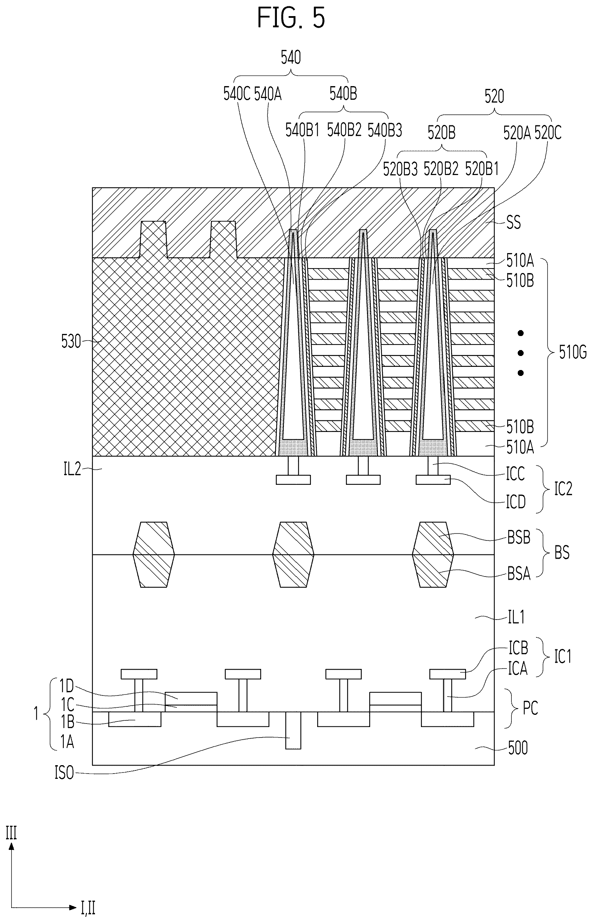

FIG. 5 is a drawing illustrating a semiconductor device according to an embodiment of the present disclosure. Hereinafter, a content that overlaps the content described above is omitted.

Referring to FIG. 5, the semiconductor device may include a substrate 500, a peripheral circuit PC, a source structure SS, a bonding structure BS, a gate structure 510G, channel structures 520, a slit structure 530, a dummy structure 540, an element isolation layer ISO, a first interconnection structure IC1, a second interconnection structure IC2, a first interlayer insulating layer IL1, and a second interlayer insulating layer IL2.

The peripheral circuit PC may be located on the substrate 500. The peripheral circuit PC may include a transistor 1. The transistor 1 may include junctions 1A and 1B, a gate electrode 1D, and a gate insulating layer 1C. The element isolation layer ISO may be located in the substrate 500, an active region may be defined by the element isolation layer ISO, and the transistor 1 may be located in the active region.

The first interconnection structure IC1 may be located on the peripheral circuit PC. The first interconnection structure IC1 may be located in the first interlayer insulating layer IL1. Here, the first interlayer insulating layer IL1 may be located on the substrate 500. The first interconnection structure IC1 may include first vias ICA and first lines ICB. The first interconnection structure IC1 may include a conductive material such as tungsten. The first interlayer insulating layer IL1 may include an insulating material such as an oxide or a nitride.

The bonding structure BS may be located on the peripheral circuit PC. For example, the bonding structure BS may be located on the first interconnection structure IC1. The bonding structure BS may include first bonding pads BSA and second bonding pads BSB. The first bonding pads BSA may be located in the first interlayer insulating layer IL1. The second bonding pads BSB may be located on the first bonding pads BSA, and may be located in the second interlayer insulating layer IL2. Here, the second interlayer insulating layer IL2 may be located on the first interlayer insulating layer IL1. The bonding structure BS may include a conductive material such as copper. The second interlayer insulating layer IL2 may include an insulating material such as an oxide or a nitride.

The second interconnection structure IC2 may be located on the bonding structure BS. The second interconnection structure IC2 may be located in the second interlayer insulating layer IL2. The second interconnection structure IC2 may include second vias ICC and second lines ICD. Although not shown in the drawing, the second interconnection structure IC2 may be connected to the bonding structure BS. For example, at least one of the second vias ICC may be connected to the second bonding pad BSB. The second interconnection structure IC2 may include a conductive material such as tungsten.

The gate structure 510G may include insulating layers 510A and conductive layers 510B alternately stacked. The channel structures 520 may extend into the source structure SS through the gate structure 510G. Here, the source structure SS may be located on the gate structure 510G. Each of the channel structures 520 may include a real channel layer 520A, a real memory layer 520B surrounding the real channel layer 520A, and a real insulating core 520C in the real channel layer 520A. Here, the channel layer 520A may be connected to the source structure SS. Here, the real memory layer 520B may include a real tunneling layer 520B1, a real data storage layer 520B2, and a real blocking layer 520B3. The real tunneling layer 520B1 and the real blocking layer 520B3 may include an oxide, and the real data storage layer 520B2 may include a nitride.

The dummy structure 540 may extend into the source structure SS through the gate structure 510G. The dummy structure 540 may have a structure similar to the channel structures 520. For example, the dummy structure 540 may include a dummy channel layer 540A, a dummy memory layer 540B surrounding the dummy channel layer 540A, and a dummy insulating core 540C in the dummy channel layer 540A. The dummy channel layer 540A may correspond to the real channel layer 520A, the dummy memory layer 540B may correspond to the real memory layer 520B, and the dummy insulating core 540C may correspond to the real insulating core 520C. The dummy memory layer 540B may include a dummy tunneling layer 540B1, a dummy data storage layer 540B2, and a dummy blocking layer 540B3. The dummy tunneling layer 540B1 and the dummy blocking layer 540B3 may include an oxide, and the dummy data storage layer 540B2 may include a nitride.

The slit structure 530 may extend into the source structure SS through the gate structure 510G. The slit structure 530 may include an insulating material, a conductive material, or a semiconductor material.

For reference, the dummy structure 540 may have a shape similar to a shape of the dummy structures 240 and 340 of FIGS. 2B and 3B in addition to having the structure similar to the channel structures 520. The slit structure 530 may have a shape similar to a shape of the slit structures 130, 230, 330, and 430 of FIGS. 1B, 2B, 3B, and 4.

According to the structure described above, the semiconductor device may include the bonding structure BS. The bonding structure BS may be located on the peripheral circuit PC, and may be electrically connected to the peripheral circuit PC.

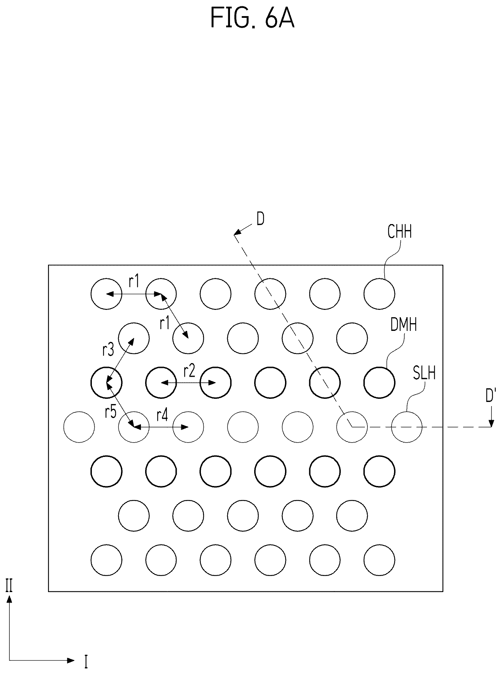

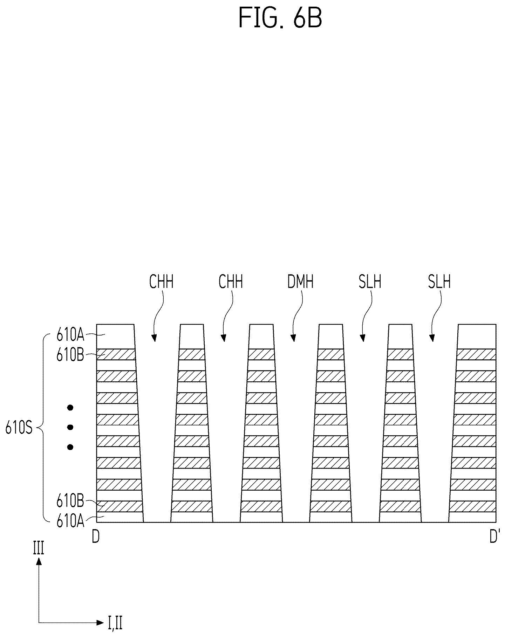

FIGS. 6A, 6B, 7A, 7B, 8A, 8B, 9A, 9B, 10A, and FIG. 10B are drawings illustrating a method of manufacturing a semiconductor device according to an embodiment of the present disclosure. FIGS. 6A, 7A, 8A, 9A, and 10A are plan views, and FIGS. 6B, 7B, 8B, 9B, and 10B are D-D' cross-sectional views of FIGS. 6A, 7A, 8A, 9A, and 10A, respectively. Hereinafter, a content that overlaps the content described above is omitted.

Referring to FIGS. 6A and 6B, a stack 610S may be formed by alternately stacking first material layers 610A and second material layers 610B. Here, the first material layers 610A may include an insulating material such as an oxide, and the second material layers 610B may include a sacrificial material such as a nitride.

Subsequently, channel holes CHH, dummy holes DMH, and slit holes SLH extending through the stack 610S may be formed. Here, the dummy holes DMH may be formed between the channel holes CHH and the slit holes SLH. A stack direction may mean a third direction III crossing a first direction I and a second direction II based on a plane defined by the first direction I and the second direction II crossing the first direction I.

The channel holes CHH may be formed to be spaced apart from each other by a first interval r1, the dummy holes DMH may be formed to be spaced apart from each other by a second interval r2, and the slit holes SLH may be formed to be spaced apart from each other by a fourth interval r4. Here, the first interval r1, the second interval r2, and the fourth interval r4 may be substantially equal.

Among the channel holes CHH, channel holes CHH located adjacent to the dummy holes DMH may be formed spaced apart from the dummy holes DMH by a third interval r3, and the dummy holes DMH and the slit holes SLH may be formed spaced apart from the dummy holes DMH by a fifth interval r5. Here, the third interval r3 and the fifth interval r5 may be substantially equal to the first interval r1.

When forming the channel holes CHH, the dummy holes DMH and the slit holes SLH may be formed. The channel holes CHH, the dummy holes DMH, and the slit holes SLH may be formed simultaneously, and may be formed to be arranged in a zigzag form in the first direction I and the second direction II. Here, the channel holes CHH, the dummy holes DMH, and the slit holes SLH may be formed to be spaced apart from each other by substantially equal first interval r1. The words "simultaneous" and "simultaneously" as used herein with respect to processes mean that the processes take place on overlapping intervals of time. For example, if a first process takes place over a first interval of time and a second process takes place simultaneously over a second interval of time, then the first and second intervals at least partially overlap each other such that there exists a time at which the first and second processes are both taking place.

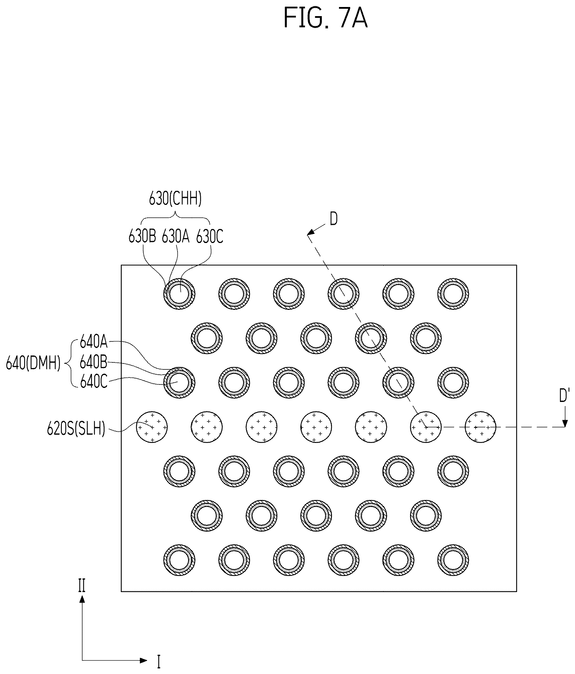

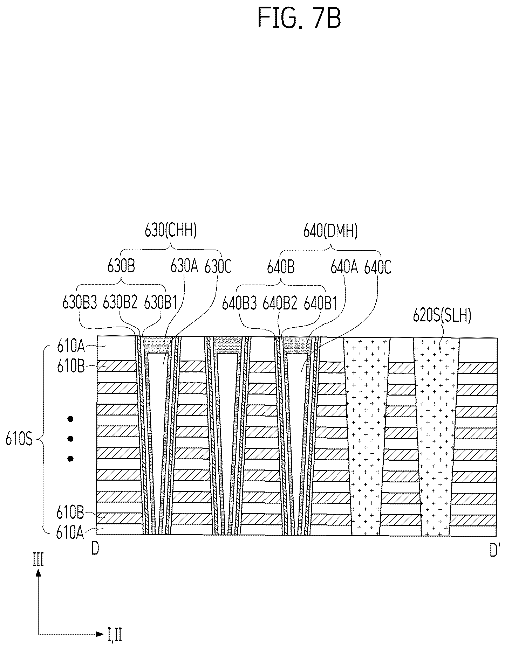

Referring to FIGS. 7A and 7B, a sacrificial material such as carbon, tungsten, or a metal nitride may be formed in the channel holes CHH, the dummy holes DMH, and the slit holes SLH. Subsequently, the sacrificial material formed in the channel holes CHH and the dummy holes DMH may be removed. At this time, the sacrificial material formed in the slit holes SLH may remain as sacrificial structures 620S.

Subsequently, channel structures 630 may be formed in the channel holes CHH, respectively. Here, each of the channel structures 630 may include a real channel layer 630A, a real memory layer 630B surrounding the real channel layer 630A, and a real insulating core 630C in the real channel layer 630A. Here, the real memory layer 630B may include a real tunneling layer 630B1, a real data storage layer 630B2, and a real blocking layer 630B3. The real tunneling layer 630B1 and the real blocking layer 630B3 may include an oxide, and the real data storage layer 630B2 may include a nitride.

Dummy structures 640 may be formed in the dummy holes DMH, respectively. When forming the channel structures 630, the dummy structures 640 may be formed. In an embodiment, a manufacturing cost of the semiconductor device may be reduced by unifying a process of forming the channel structures 630 and the dummy structures 640. Therefore, in an embodiment, the dummy structures 640 may have a structure similar to the channel structures 630. For example, each of the dummy structures 640 may include a dummy channel layer 640A, a dummy memory layer 640B surrounding the dummy channel layer 640A, and a dummy insulating core 640C in the dummy channel layer 640A. The dummy memory layer 640B may include a dummy tunneling layer 640B1, a dummy data storage layer 640B2, and a dummy blocking layer 640B3. The dummy tunneling layer 640B1 and the dummy blocking layer 640B3 may include an oxide, and the dummy data storage layer 640B2 may include a nitride.

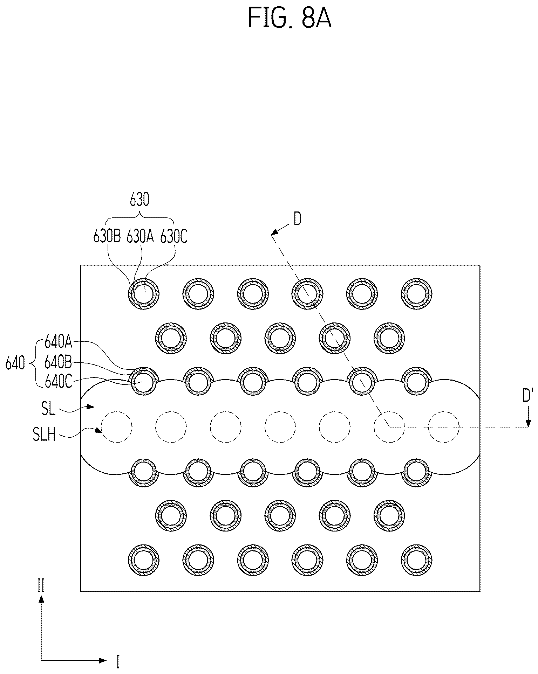

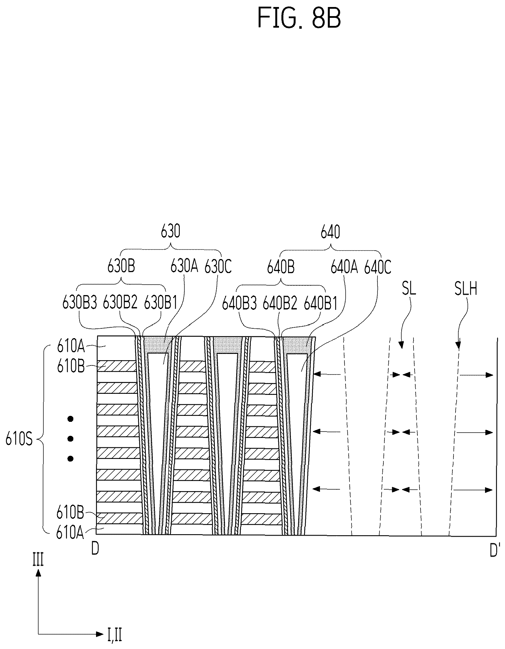

Referring to FIGS. 8A and 8B, slit holes SLH may be opened by removing the sacrificial structures 620S formed in the slit holes SLH. Subsequently, slits SL exposing the dummy structures 640 may be formed by expanding the slit holes SLH. For example, the first material layers 610A may be selectively removed to expand the slit holes SLH, and then the second material layers 610B may be selectively removed to expand the slit holes SLH, thereby forming the slit SL in which the slit holes SLH are connected as one.

When expanding the slit holes SLH, a portion of the dummy structures 640 may be etched. For example, when selectively removing the first material layers 610A, a portion of the dummy blocking layer 640B3 of the dummy structures 640 may be etched. When selectively removing the second material layers 610B, a portion of the dummy data storage layer 640B2 of the dummy structures 640 may be etched. When expanding the slit holes SLH, in an embodiment, damage to the channel structures 630 may be prevented or reduced as a portion of the dummy structures 640 is etched.

When the dummy holes are not formed, channel holes may be formed at a location of the dummy holes. In an embodiment, when an interval between the channel holes and the slit holes is small, channel structures located adjacent to the slit holes may be damaged in a process of expanding the slit holes. On the other hand, in an embodiment, when the interval between the channel holes and the slit holes is large, a limit exists in improving an integration degree of the semiconductor device.

In order to improve the integration degree of the semiconductor device while preventing or mitigating damage to the channel structures, only the interval between the slit holes and the channel holes located adjacent to the slit holes may be largely adjusted. For example, while the channel holes are regularly formed to be spaced apart from each other by a substantially equal interval and arranged in the first direction I and the second direction II, the interval between the slit holes and the channel holes located adjacent to the slit holes may be formed to be greater than the interval between the channel holes. In other words, regularity may be broken as the interval between the channel holes and the slit holes become different. In this case, a difference may occur in a width or the like of the channel holes formed spaced apart from the slit holes and the channel holes formed adjacent to the slit holes due to a process reason. Here, a difference may occur in a shape of the channel structures formed in the channel holes, an electrical characteristic of the channel structures, and the like. For example, shapes of each of the channel structures may be differently formed, and a difference may occur in an operation speed and the like of a program operation of each of the channel structures. Therefore, reliability of the semiconductor device may be weakened.

According to an embodiment of the present disclosure, the channel holes CHH, the dummy holes DMH, and the slit holes SLH may be formed to be spaced apart from each other by a substantially equal intervals. In other words, in an embodiment, the holes CHH, DMH, and SLH may be formed regularly while maintaining the interval between the channel holes CHH, the dummy holes DMH, and the slit holes SLH. In this case, in an embodiment, a width and the like of the formed holes CHH, DMH, and SLH may be uniformly formed, and a shape and the like of the channel structures 630 may be uniformly formed regardless of the channel holes CHH formed adjacent to the slit holes SLH and the channel holes CHH formed spaced apart from the slit holes SLH. Therefore, in an embodiment, reliability of the semiconductor device may be improved.

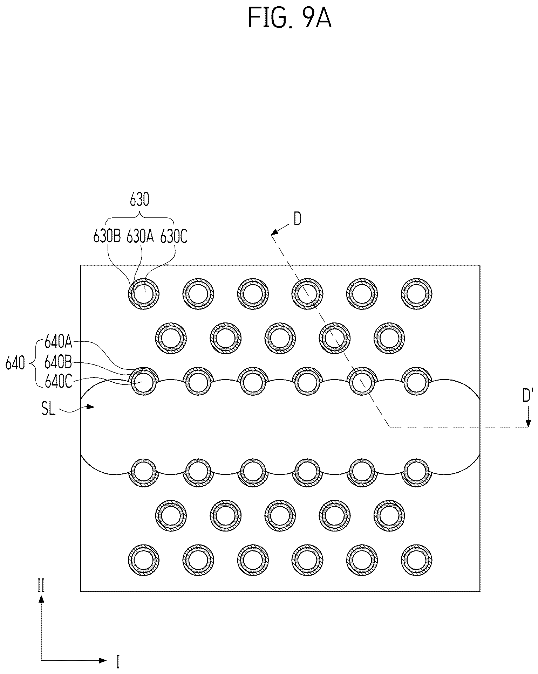

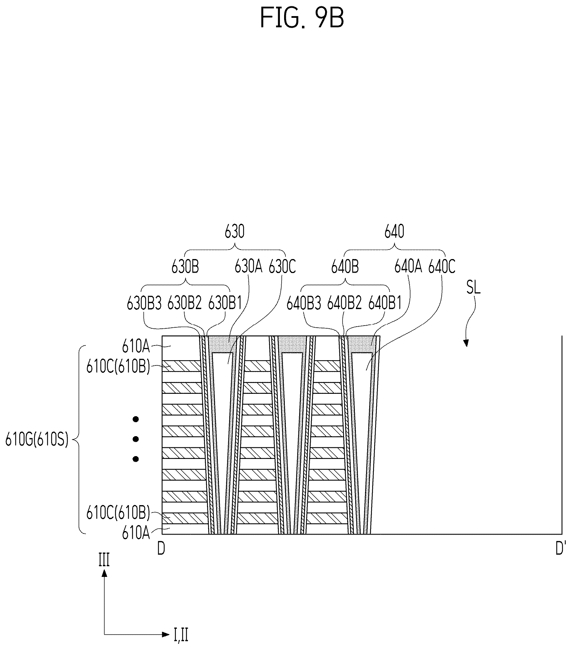

Referring to FIGS. 9A and 9B, the second material layers 610B may be replaced with third material layers 610C through the slits SL. First, openings may be formed by removing the second material layers 610B through the slits SL. Subsequently, the third material layers 610C may be formed in the openings, respectively. Accordingly, a gate structure 610G in which the first material layers 610A and the third material layers 610C are alternately stacked may be formed. Here, the third material layers 610C may include a conductive material such as tungsten.

For reference, when the second material layers 610B include a conductive material, a process of replacing the second material layers 610B with the third material layers 610C may be omitted. In this case, the stack 610S may be used as the gate structure.

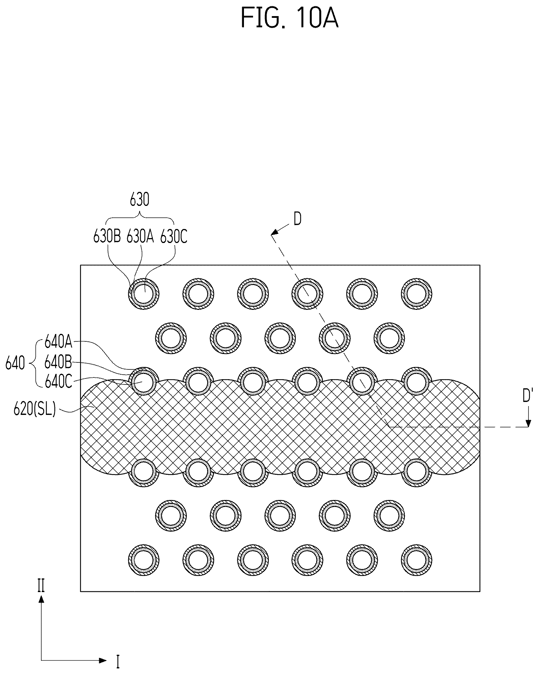

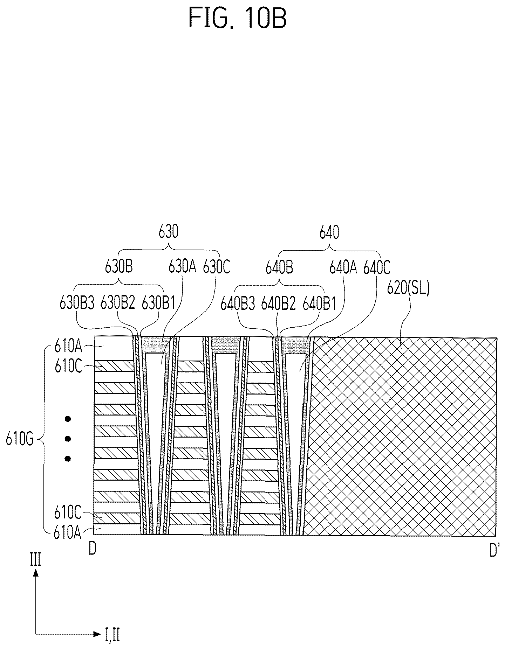

Referring to FIGS. 10A and 10B, a slit structure 620 may be formed in the slit SL. Here, the slit structure 620 may include an insulating material such as an oxide. Alternatively, the slit structure 620 may include at least one of a conductive material or a semiconductor material.

According to an embodiment of the manufacturing method described above, the channel holes CHH, the dummy holes DMH, and the slit holes SLH may be formed at a uniform interval. In other words, the holes CHH, DMH, and SLH may be regularly formed. In this case, in an embodiment, regardless of a location of the channel holes CHH, a shape and the like of the channel structures 630 may be uniformly formed in the channel holes CHH. Therefore, in an embodiment, reliability of the semiconductor device may be improved.

In addition, in an embodiment, the channel structures 630 may be prevented or mitigated from being damaged in a process of expanding the slit holes SLH, by forming the dummy holes DMH for forming the dummy structures 640 between the channel holes CHH and the slit holes SLH. Here, the dummy structures 640 may be formed simultaneously when forming the channel structures 630. Therefore, in an embodiment, a manufacturing cost of the semiconductor device may be reduced by unifying a process.

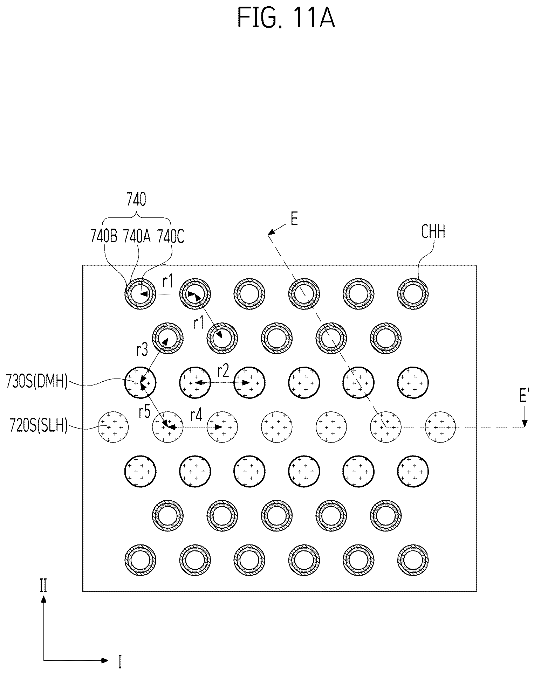

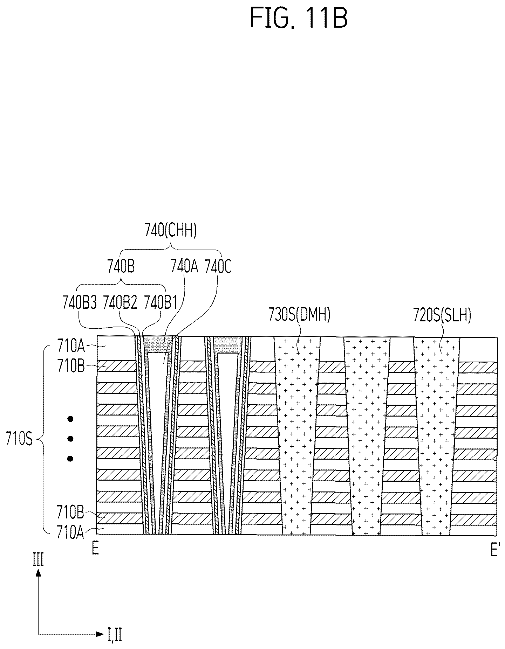

FIGS. 11A, 11B, 12A, 12B, 13A, 13B, 14A, and 14B are drawings illustrating a method of manufacturing a semiconductor device according to an embodiment of the present disclosure. FIGS. 11A, 12A, 13A, and 14A are plan views, and FIGS. 11B, 12B, 13B, and 14B are E-E' cross-sectional views of FIGS. 11A, 12A, 13A, and 14A, respectively. Hereinafter, a content that overlaps the content described above is omitted.

Referring to FIGS. 11A and 11B, a stack 710S may be formed by alternately stacking first material layers 710A and second material layers 710B. Here, the first material layers 710A may include an insulating material such as an oxide, and the second material layers 710B may include a sacrificial material such as a nitride.

Subsequently, channel holes CHH, dummy holes DMH, and slit holes SLH extending through the stack 710S may be formed. Here, dummy holes DMH may be formed between the channel holes CHH and the slit holes SLH. The channel holes CHH may be formed to be spaced apart from each other by a first interval r1, the dummy holes DMH may be formed to be spaced apart from each other by a second interval r2 substantially equal to the first interval r1, and the slit holes SLH may be formed to be spaced apart from each other by a fourth interval r4 substantially equal to the first interval r1. Among the channel holes CHH, channel holes CHH located adjacent to the dummy holes DMH may be formed to be spaced apart from the dummy holes DMH by a third interval r3 substantially equal to the first interval r1, and the dummy holes DMH and the slit holes SLH may be formed to be spaced apart from each other by a fifth interval r5 substantially equal to the first interval r1.

Subsequently, a sacrificial material such as carbon, tungsten, or a metal nitride may be formed in the channel holes CHH, the dummy holes DMH, and the slit holes SLH. In this case, first sacrificial structures 720S may be formed in the slit holes SLH. Second sacrificial structures 730S may be formed in the dummy holes DMH.

Subsequently, the sacrificial material formed in the channel holes CHH may be removed. Subsequently, channel structures 740 may be formed in the channel holes CHH, respectively. Here, each of the channel structures 740 may include a real channel layer 740A, a real memory layer 740B surrounding the real channel layer 740A, and a real insulating core 740C in the real channel layer 740A. The dummy channel layer 740A may correspond to the real channel layer 720A, the dummy memory layer 740B may correspond to the real memory layer 720B, and the dummy insulating core 740C may correspond to the real insulating core 720C. The dummy memory layer 740B may include a dummy tunneling layer 740B1, a dummy data storage layer 740B2, and a dummy blocking layer 740B3. The dummy tunneling layer 740B1 and the dummy blocking layer 740B3 may include an oxide, and the dummy data storage layer 740B2 may include a nitride.

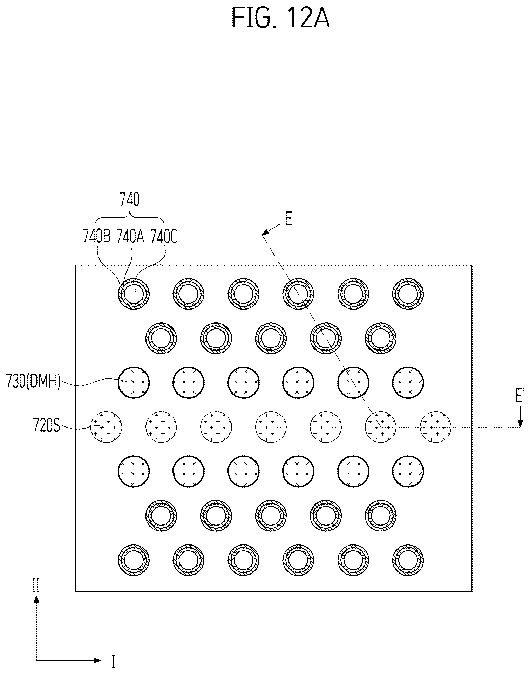

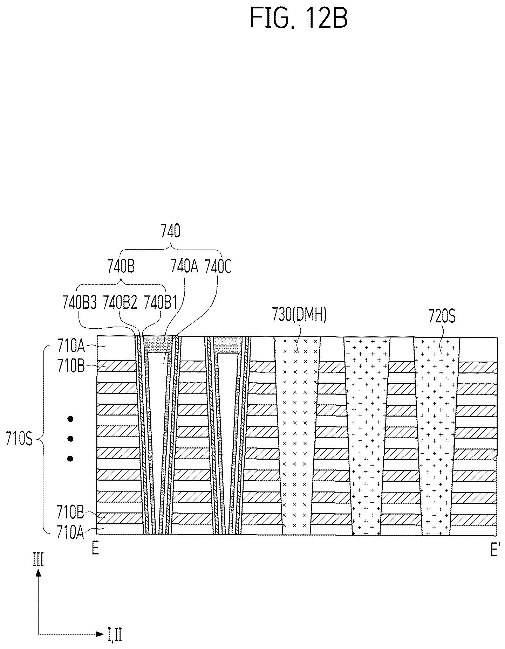

Referring to FIGS. 12A and 12B, the dummy holes DMH may be opened by removing the second sacrificial structures 730S. Subsequently, the dummy structures 730 may be formed in the dummy holes DMH. The dummy structures 730 may be formed as a single layer. Here, the dummy structures 730 may include an insulating material such as an oxide.

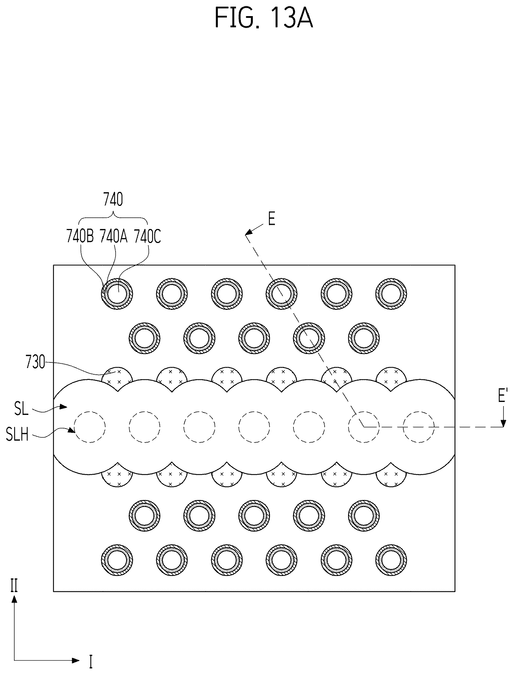

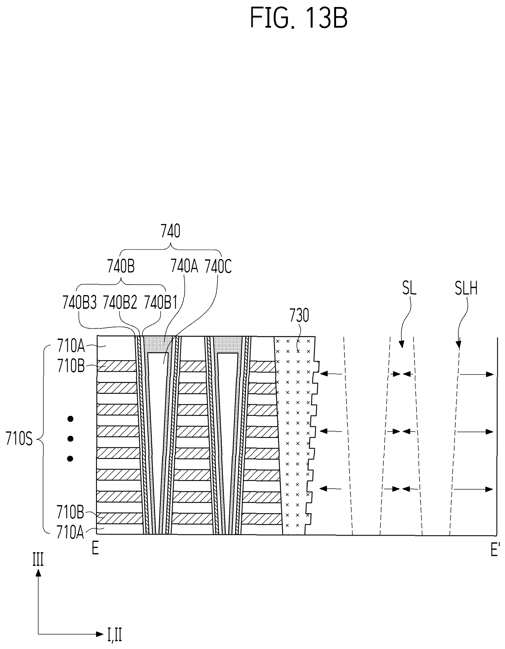

Referring to FIGS. 13A and 13B, the slit holes SLH may be opened by removing the first sacrificial structures 720S formed in the slit holes SLH. Subsequently, a slit SL exposing the dummy structures 730 may be formed by expanding the slit holes SLH. For example, the first material layers 710A may be selectively removed to expand the slit holes SLH, and then the second material layers 710B may be selectively removed to expand the slit holes SLH, thereby forming the slit SL in which the slit holes SLH are connected as one.

When expanding the slit holes SLH, a portion of the dummy structures 730 may be etched. For example, when selectively removing the first material layers 710A, a portion of the dummy structures 730 may be etched. This is because the first material layers 710A and the dummy structures 730 may include substantially equal material. In an embodiment, when expanding the slit holes SLH, damage to the channel structures 740 due to etching of a portion of the dummy structures 730 may be prevented or reduced.

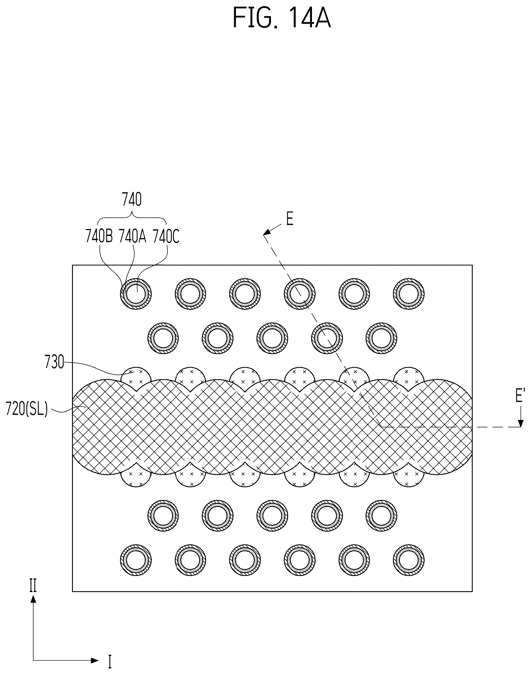

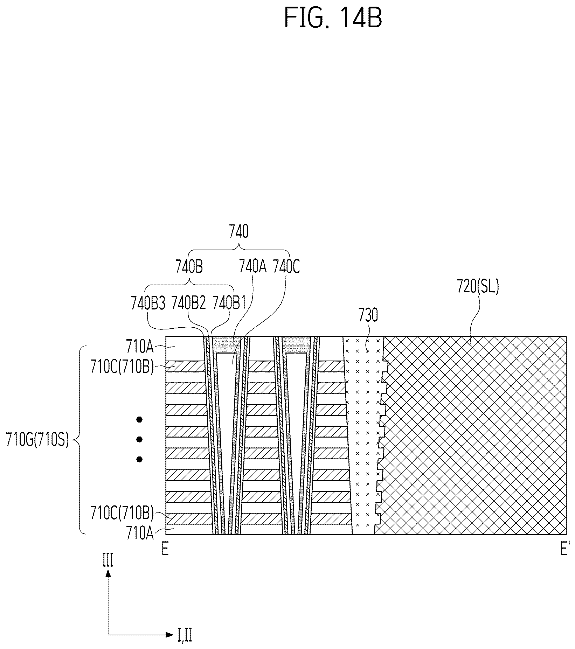

Referring to FIGS. 14A and 14B, the second material layers 710B may be replaced with third material layers 710C through the slit SL. Accordingly, a gate structure 710G in which the first material layers 710A and the third material layers 710C are alternately stacked may be formed. Here, the third material layers 710C may include a conductive material such as tungsten.

Subsequently, a slit structure 720 may be formed in the slit SL. Here, the slit structure 720 may include at least one of an insulating material, a conductive material, or a semiconductor material.

According to an embodiment of the manufacturing method described above, by forming the dummy holes DMH for forming the dummy structures 730 between the channel holes CHH and the slit holes SLH, the channel structures 740 may be prevented or mitigated from being damaged in a process of expanding the slit holes SLH.

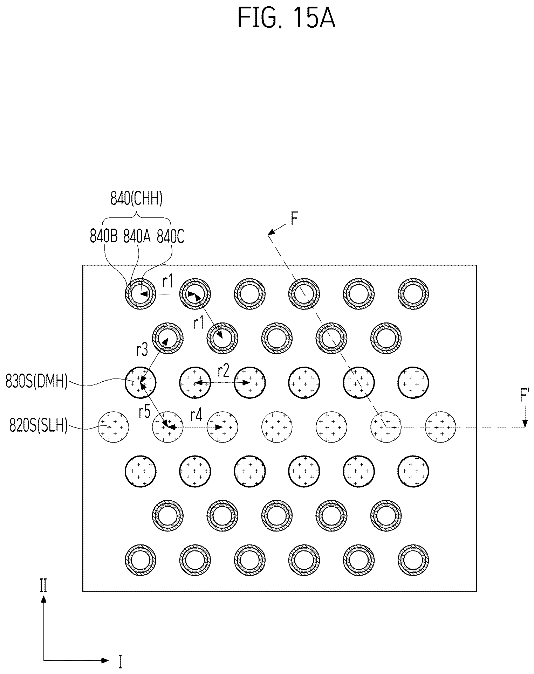

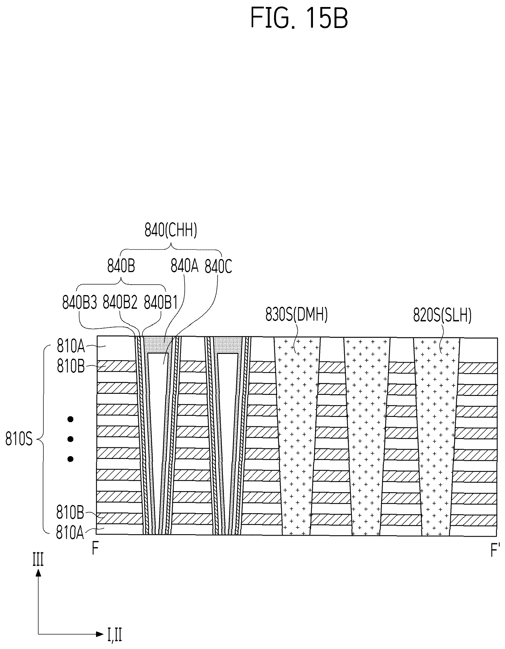

FIGS. 15A, 15B, 16A, 16B, 17A, 17B, 18A, and 18B are drawings illustrating a method of manufacturing a semiconductor device according to an embodiment of the present disclosure. FIGS. 15A, 16A, 17A, and 18A are plan views, and FIGS. 15B, 16B, 17B, and 18B are F-F' cross-sectional views of FIGS. 15A, 16A, 17A, and 18A, respectively. Hereinafter, a content that overlaps the content described above is omitted.

Referring to FIGS. 15A and 15B, a stack 810S may be formed by alternately stacking first material layers 810A and second material layers 810B. Here, the first material layers 810A may include an insulating material such as an oxide, and the second material layers 810B may include a sacrificial material such as a nitride.

Subsequently, channel holes CHH, dummy holes DMH, and slit holes SLH extending through the stack 810S may be formed. Here, the dummy holes DMH may be formed between the channel holes CHH and the slit holes SLH. The channel holes CHH may be formed to be spaced apart from each other by a first interval r1, the dummy holes DMH may be formed to be spaced apart from each other by a second interval r2 substantially equal to the first interval r1, and the slit holes SLH may be formed to be spaced apart from each other by a fourth interval r4 substantially equal to the first interval r1. Among the channel holes CHH, channel holes CHH located adjacent to the dummy holes DMH may be formed to be spaced apart from the dummy holes DMH by a third interval r3 substantially equal to the first interval r1, and the dummy holes DMH and the slit holes SLH may be formed to be spaced apart from each other by a fifth interval r5 substantially equal to the first interval r1.

Subsequently, a sacrificial material such as carbon, tungsten, or a metal nitride may be formed in the channel holes CHH, the dummy holes DMH, and the slit holes SLH. In this case, first sacrificial structures 820S may be formed in the slit holes SLH. Second sacrificial structures 830S may be formed in the dummy holes DMH.

Subsequently, the sacrificial material formed in the channel holes CHH may be removed. Subsequently, channel structures 840 may be formed in the channel holes CHH, respectively. Here, each of the channel structures 840 may include a real channel layer 840A, a real memory layer 840B surrounding the real channel layer 840A, and a real insulating core 840C in the real channel layer 840A. The dummy channel layer 840A may correspond to the real channel layer 820A, the dummy memory layer 840B may correspond to the real memory layer 820B, and the dummy insulating core 840C may correspond to the real insulating core 820C. The dummy memory layer 840B may include a dummy tunneling layer 840B1, a dummy data storage layer 840B2, and a dummy blocking layer 840B3. The dummy tunneling layer 840B1 and the dummy blocking layer 840B3 may include an oxide, and the dummy data storage layer 840B2 may include a nitride.

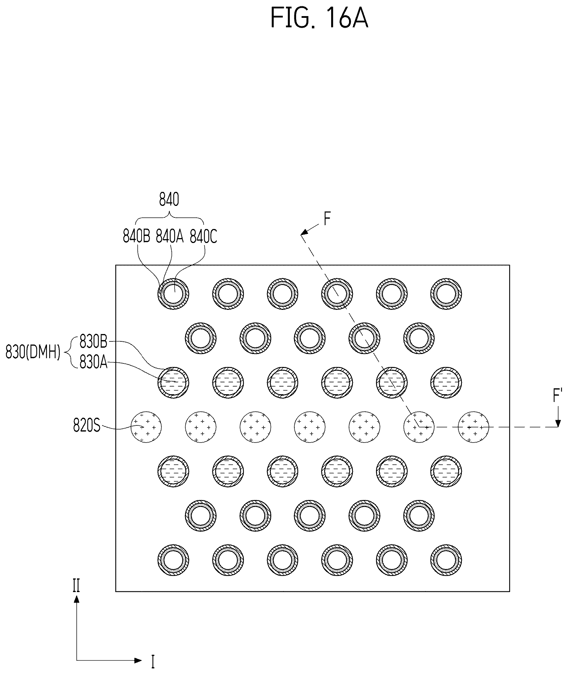

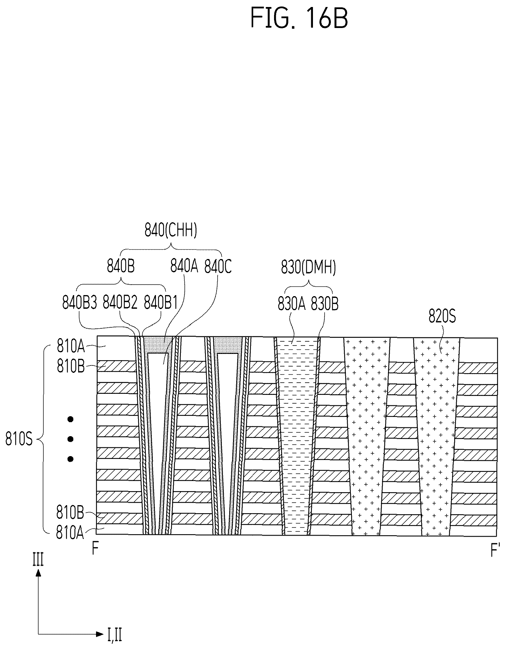

Referring to FIGS. 16A and 16B, dummy holes DMH may be opened by removing the second sacrificial structures 830S. Subsequently, dummy structures 830 may be formed in the dummy holes DMH. The dummy structures 830 may be formed as multiple layers. For example, the dummy structures 830 may include a first portion 830A and a second portion 830B surrounding the first portion 830A. Here, the first portion 830A may include a material having an etching selectivity with respect to the second portion 830B. For example, the first portion 830A may include polysilicon, and the second portion 830B may include an oxide.

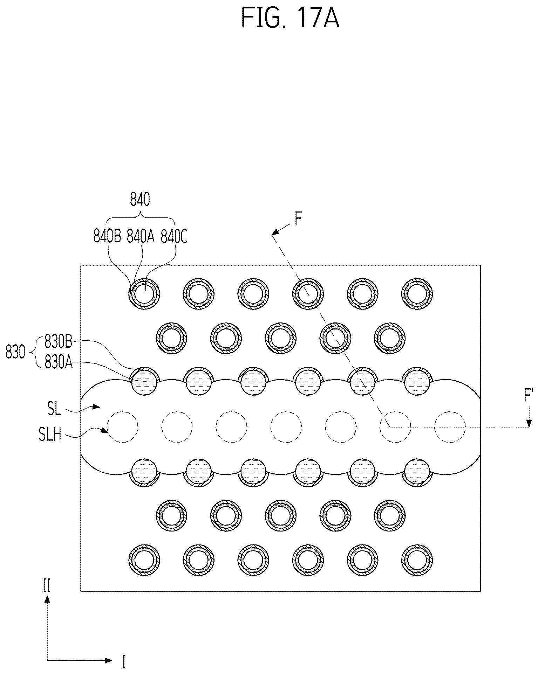

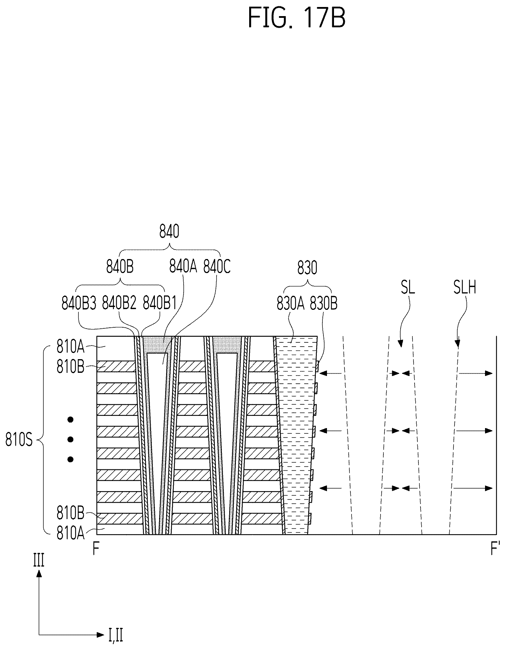

Referring to FIGS. 17A and 17B, slit holes SLH may be opened by removing the first sacrificial structures 820S formed in the slit holes SLH. Subsequently, a slit SL exposing the dummy structures 830 may be formed by expanding the slit holes SLH. For example, the first material layers 810A may be selectively removed to expand the slit holes SLH, and then the second material layers 810B may be selectively removed to expand the slit holes SLH, thereby forming a slit SL in which the slit holes SLH are connected as one.

When expanding the slit holes SLH, a portion of the dummy structures 830 may be etched. For example, when selectively removing the first material layers 810A, a portion of the second portion 830B of the dummy structures 830 may be etched. This is because the first material layers 810A and the second portions 830B may include substantially equal material. Here, in an embodiment, even though the second portions 830B are excessively etched, because the first portion 830A is not etched, damage to the channel structures 840 may be prevented or reduced when expanding the slit holes SLH.

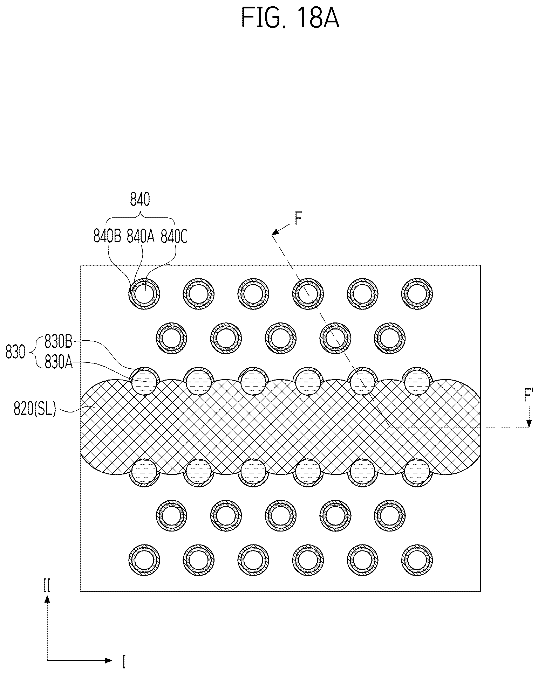

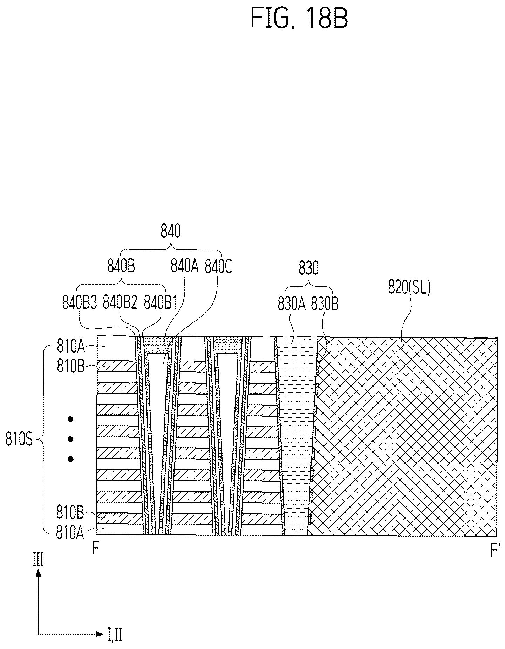

Referring to FIGS. 18A and 18B, the second material layers 810B may be replaced with third material layers 810C through the slit SL. Accordingly, a gate structure 810G in which the first material layers 810A and the third material layers 810C are alternately stacked may be formed. Here, the third material layers 810C may include a conductive material such as tungsten.

Subsequently, a slit structure 820 may be formed in the slit SL. Here, the slit structure 720 may include at least one of an insulating material, a conductive material, or a semiconductor material.

According to an embodiment of the manufacturing method described above, the dummy holes DMH for forming the dummy structures 830 may be formed between the channel holes CHH and the slit holes SLH. Here, the dummy structures 830 may include a first portion 830A and a second portion 830B including different materials. Therefore, in an embodiment, even though the second portion 830B is etched in a process of expanding the slit holes SLH, because the first portion 830A is not etched, the channel structures 840 may be prevented or mitigated from being damaged.

Although embodiments according to the technical spirit of the present disclosure have been described with reference to the accompanying drawings, this is only for describing an embodiment according to the concept of the present disclosure, and the present disclosure is not limited to the above-described embodiments. In the scope of the technical spirit of the present disclosure described in the claims, various forms of substitution, modification, and change of the embodiments will be possible by those skilled in the art to which the present disclosure belongs, and these also belong to the scope of the present disclosure.

## Claims

1. A semiconductor device comprising:
a gate structure including insulating layers and conductive layers alternately stacked in a third direction;
channel structures extending through the gate structure in the third direction and arranged in a first direction and a second direction crossing the first direction;
a slit structure extending in the first direction and including a body portion and protrusions protruding from the body portion in the second direction; and
dummy structures arranged in the first direction between the channel structures and the slit structure and respectively contacting the protrusions.

2. The semiconductor device of claim 1, wherein the channel structures are spaced apart from each other by a first interval, and
channel structures located adjacent to the dummy structures among the channel structures are spaced apart from corresponding adjacent dummy structures, respectively, by a third interval, the third interval is substantially equal to the first interval.

3. The semiconductor device of claim 2, wherein the dummy structures are spaced apart from each other by a second interval substantially equal to the first interval.

4. The semiconductor device of claim 1, wherein the protrusions protrude in the second direction between the dummy structures.

5. The semiconductor device of claim 1, wherein each of the channel structures includes a real channel layer, a real memory layer surrounding the real channel layer, and a real insulating core surrounded by the real channel layer, and
each of the dummy structures includes a dummy channel layer, a dummy memory layer surrounding the dummy channel layer, and a dummy insulating core surrounded by the dummy channel layer.

6. The semiconductor device of claim 5, wherein the dummy memory layer surrounds a portion of the dummy channel layer.

7. The semiconductor device of claim 1, wherein each of the dummy structures includes a first portion extending through the gate structure and second portions protruding from the first portion.

8. The semiconductor device of claim 1, wherein each of the dummy structures includes a first portion extending through the gate structure, a second portion surrounding the first portion, and third portions protruding from the first portion.

9. The semiconductor device of claim 1, further comprising:
a peripheral circuit; and
a source structure located between the peripheral circuit and the gate structure.

10. The semiconductor device of claim 1, further comprising:
a peripheral circuit;
a bonding structure located on the peripheral circuit; and
a source structure located on the gate structure.

11. A semiconductor device comprising:
a gate structure including insulating layers and conductive layers alternately stacked in a third direction;
channel structures extending through the gate structure in the third direction and arranged in a first direction and a second direction crossing the first direction;
a slit structure extending in the first direction; and
dummy structures arranged in the first direction between the channel structures and the slit structure,
wherein the channel structures are spaced apart from each other by a first interval, and
channel structures located adjacent to the dummy structures among the channel structures are spaced apart from corresponding adjacent dummy structures, respectively, by a third interval, the third interval is substantially equal to the first interval.

12. The semiconductor device of claim 11, wherein the dummy structures are spaced apart from each other by a second interval substantially equal to the first interval.

13. The semiconductor device of claim 11, wherein the slit structure includes a body portion and protrusions protruding from the body portion in the second direction, and the protrusions protrude between the dummy structures in the second direction.

14. The semiconductor device of claim 13, wherein the dummy structures contact the protrusions, respectively.

15. The semiconductor device of claim 11, wherein each of the channel structures includes a real channel layer, a real memory layer surrounding the real channel layer, and a real insulating core surrounded by the real channel layer, and
each of the dummy structures includes a dummy channel layer, a dummy memory layer surrounding the dummy channel layer, and a dummy insulating core surrounded by the dummy channel layer.
